# EUROPEAN PATENT APPLICATION

(11) **EP 1 432 045 A2**
(43) Date of publication of application: **23.06.2004**
(21) Application number: 03029205.6
(22) Date of filing: 18.12.2003
(51) Int. Cl.: H01L 31/12

(54) **Optocoupler and its manufacturing method**

(30) Priority: 18.12.2002 JP 2002366940
(71) Applicant: TDK Corporation, Tokyo 103-8272 (JP)
(72) Inventor: Lo, Adrian Wing Fai, Tokyo 103-8272 (JP); Hata, Kenjiro, Tokyo 103-8272 (JP); Kineri, Tohru, Tokyo 103-8272 (JP); Hanashima, Naoki, Tokyo 103-8272 (JP)
(74) Representative: HOFFMANN - EITLE

(57) **Abstract**

The present invention realizes easy packaging of an optical module without using a molding machine and metal mold.

The optical module has a PD platform and an LE platform in a package box. A recess is formed at the top of one sidewall of the package box on the side from which a ferrule projects. Further, adhesive is used to fill the gap between the recess and ferrule. The adhesive is further applied on the part of the ferrule near the recess. The internal space of the package box accommodating the platforms is filled with thermosetting resin, after which the thermosetting resin is cured. Thus, the whole platform body is finally encapsulated with the resin. The applied adhesive prevents the thermosetting resin from flowing to the outside.

## Description

### BACKGROUND OF THE INVENTION

The present invention relates to an optical module and a method of fabricating the same, and more particularly, to an optical module which can be produced by an easy process and at low cost, and a method of fabricating the same.

### THE PRIOR ART

The advent of the Internet allows one to access and manipulate huge quantities of information in real time. Though copper wire, optical fiber, wireless means and the like are used to send and receive information, the optical fiber is especially superior for transmitting huge volumes of information at high speed. Thus, it is expected that the optical fiber will be extended into every household in the future.

However, when connecting terminal devices by optical fibers, it is necessary to provide a so-called optical module between the optical fiber and each terminal device, since terminal devices do not use optical signals but electric signals for information processing. The optical module transforms the optical signals received from the optical fiber into electric signals and provides the electric signals to the terminal device, and further transforms the electric signals received from the terminal device into the optical signals and supplies the optical signals to the optical fiber. Various types of optical modules have been proposed in the art.

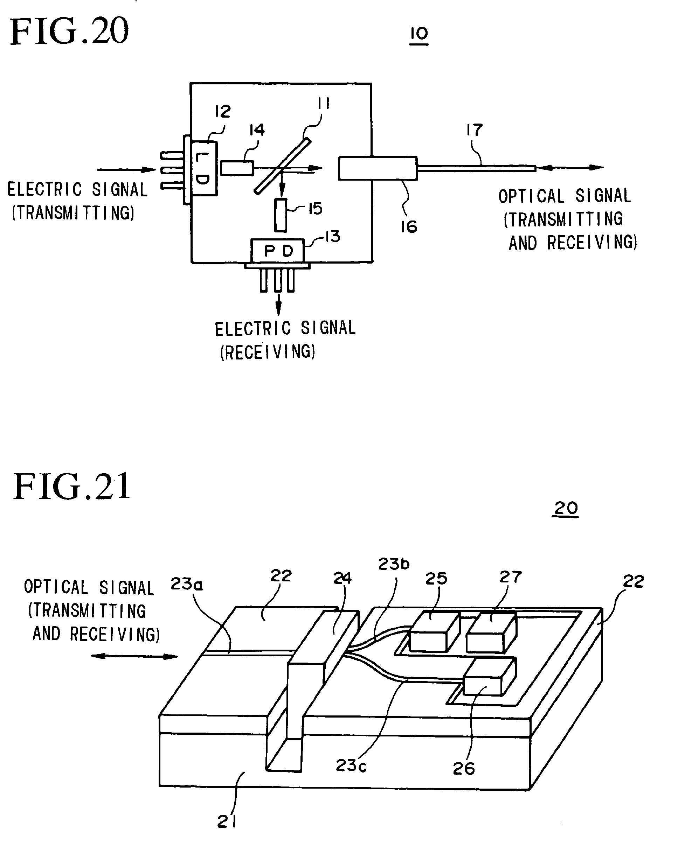

Fig. 20 is a schematic view showing the structure of a conventional optical module.

As shown in Fig.20, the optical module 10 can transmit and receive signals in the WDM (wavelength division multiplex) mode. The optical module has a structure wherein a WDM filter 11, a laser diode (LD) 12, a photo diode (PD) 13 and optical lenses 14 and 15 are contained in a package 16. The WDM filter 11 is an optical filter that passes light of a predetermined wavelength (for example, about 1.3 µm) used for transmission and reflects light of a predetermined wavelength (for example, about 1.55 µm) used for reception, and it is positioned on the optical path. The laser diode 12 is an element for transforming a supplied electric signal into an optical signal. Light of the predetermined wavelength of, for example, about 1.3 µm emitted from the laser diode 12 is supplied to an optical fiber 17 through the optical lens 14 and the WDM filter 11. The photo-diode 13 is an element for transforming a received optical signal into an electric signal. Light of the predetermined wavelength of, for example, about 1.55 µm supplied from the optical fiber 17 is reflected by the WDM filter 11, after which it is sent to the photo-diode 13 through the optical lens 15, and is transformed into electric signals. It is therefore possible to transform the optical signals from the optical fiber 17 and supply them to the terminal device, and transform the electric signals from the terminal device and supply them to the optical filter 17. The above example of the light wavelengths assumes that the optical module 10 shown in Fig.20 is installed in a terminal device used in a home. If the optical module 10 is used on the side of the base station, the wavelengths used for transmission and reception are reversed.

However, the optical module 10 of the type shown in Fig. 20 requires high accuracy in the positioning the individual elements, and, in some cases, fine tuning by a skilled worker. For this reason, there is a problem that manufacturing efficiency is low, so that the module is not suitable for mass production.

Fig.21 is a schematic view showing the structure of another conventional optical module.

The optical module 20 shown in Fig.21 is a so-called optical waveguide embedded type optical module. The optical module 20 comprises a substrate 21, a cladding layer 22 formed on the substrate 21, core regions 23a-23c formed on a predetermined region of the cladding layer 22, a WDM filter 24 inserted in the slot formed on the substrate 21 and the cladding layer 22, a laser diode 25 provided adjacent to the end of the core region 23b, a photo-diode 26 provided adjacent to the end of core region 23c, and a monitoring photo-diode 27 which monitors the output of the laser diode 25. In the optical module 20 of such type, an optical waveguide constituted by the cladding layer 22 and core region 23a is connected to an optical fiber not shown in the drawing. Accordingly, transmission and reception in the WDM (wavelength division multiplex) mode are performed.

That is, light of the transmission wavelength (for example, about 1.3 µm) emitted from the laser diode 25 propagates through an optical waveguide consisting of the cladding layer 22 and the core region 23b, after which it is supplied to the optical waveguide consisting of the cladding layer 22 and the core region 23a through the WDM filter 24, and enters an optical fiber that is not illustrated. Moreover, light of the reception wavelength (for example, about 1.55 µm) supplied from the optical fiber (not shown) propagates through the optical waveguide consisting of the cladding layer 22 and core region 23a, after which it is supplied to the optical waveguide which consisting of the cladding layer 22 and core region 23c through the WDM filter 24, and enters the photo-diode 26. The output of the laser diode 25 is monitored by the monitoring photo-diode 27, and the output of the laser diode 25 can therefore be optimized.

The optical module 20 of the type described above is smaller than the optical module 10 of the type shown in Fig.20, and it has high productivity because it does not require the fine tuning by a skilled worker.

However, there is a problem that it is very expensive and it requires high connection accuracy between the optical fiber and the optical waveguide.

### SUMMARY OF THE INVENTION

It is therefore an object of the present invention to provide an improved optical module and a method of fabricating the same.

Another object of the present invention is to provide an optical module and a method of fabricating the same that can realize miniaturization and low cost.

Another object of the present invention is to provide an optical module that can be fabricated by an easy process and a method of fabricating the same.

The above and other objects can be accomplished by an optical module for transmitting and receiving optical signals comprising at least one transceiver unit, a package box which is a box-shaped enclosure accommodating the transceiver unit; and resin filling the package box, wherein the transceiver unit includes a die pat, at least one platform body mounted on the die pat, an optical fiber fixed on the platform body, at least one receiving photo-diode which is mounted on the platform body and transforms optical signals received through the optical fiber into electric signals, a light emitter mounted on the platform body, a filter provided to divide the optical fiber at a position between the receiving photo-diode and the light emitter, and a ferrule in which an end of the optical fiber is inserted.

According to the present invention, since the at least one platform body on which the receiving photo-diode and the light emitter are mounted is further mounted on the die pad after which these are encapsulated by the resin, the optical module is very easy to handle. Since integrated encapsulation can be performed by injecting liquid resin into the package box accommodating the transceiver unit and curing the resin, the encapsulation can be easily performed without using a molding machine and a metal mold. Further, since, differently from the conventional optical module, the optical module does not require fine tuning by a skilled worker, it has high fabrication efficiency. It is possible to realize relatively low cost, which is not possible with the optical module including the conventional optical waveguide.

In a preferred aspect of the present invention, the package box has a recess for projecting the ferrule, and the gap between the recess and the ferrule is filled with adhesive. According to this aspect of the present invention, it is possible to prevent the liquid resin filling the package box from leaking through the gap to the outside.

In a preferred aspect of the present invention, the adhesive is further applied on the upper part of the ferrule near the recess. According to this aspect of the present invention, it is possible to form a dam to confine the liquid resin filling the package box and prevent it from flowing out over the top of the ferrule.

The above and other objects can also be accomplished by a method of fabricating an optical module for transmitting and receiving optical signals comprising the steps of producing a box-shaped package box by pre-molding a lead frame, mounting on a die pad of the lead frame an LE platform equipped at least with a light emitter for generating optical signals to be transmitted, mounting on the die pad or the LE platform a PD platform equipped at least with an optical fiber, a receiving photo-diode for photoelectrically converting optical signals received through the optical fiber, a filter for separating received optical signals from transmitted optical signals, and a ferrule in which an end of the optical fiber is inserted, charging resin into the package box accommodating the PD platform body and the LE platform body, and curing the resin to encapsulate the PD platform and LE platform.

According to the present invention, since the LE platform mounted with the light emitter and the PD platform mounted with the receiving photo-diode are first mounted on the die pad and then covered by the encapsulating member, the fabricated optical module is very easy to handle. Since integrated encapsulation can be performed by injecting liquid resin into the package box accommodating the transceiver unit and curing the resin, the encapsulation can be easily performed without using a molding machine and a metal mold. Further, since, differently from the conventional optical module, the optical module does not require fine tuning by a skilled worker, it has high fabrication efficiency. It is possible to realize relatively low cost, which is not possible with the optical module including the conventional optical waveguide.

In a preferred aspect of the present invention, the step of pre-molding the lead frame includes a step of forming a recess in the package box for projecting the ferrule, and further comprises a step of injecting adhesive into a gap between the recess and the ferrule before the step of charging resin into the package box. According to this aspect of the present invention, it is possible to prevent the liquid resin filling the package box from leaking through the gap to the outside.

In a preferred aspect, the present invention further comprises a step of performing a screening test of the LE platform mounted on the die pad before mounting the PD platform. According to this aspect of the present invention, it is not necessary to perform needless processing on a product in process that has an initial failure, and is therefore possible to reduce manufacturing cost. Further, since no molding machine and metal mold is required in the final resin encapsulation after performing the screening test, it is possible to realize easy packaging. The above and other objects and features of the present invention will become apparent from the following description made with reference to the accompanying drawings.

### BRIEF DESCRIPTION OF THE DRAWINGS

Fig.1 is a plan view schematically showing the structure of an optical module 100 according to one preferred embodiment of the present invention.
Fig.2 is a side view partially showing the structure of the optical module 100.
Fig. 3 is a perspective view schematically showing the structure of a PD platform 110.
Fig.4 is a perspective view schematically showing the structure of an LE platform 120.
Fig.5 (a) and Fig.5 (b) are perspective views schematically showing the exterior of the optical module 100.
Fig.6 is a top view schematically showing the optical module 100 mounted on a printed circuit board or the like.
Fig.7 is a diagram showing a process for fabricating the optical module 100 (preparing of lead frame 105).
Fig.8 is a diagram showing a process for fabricating the optical module 100 (pre-mold).

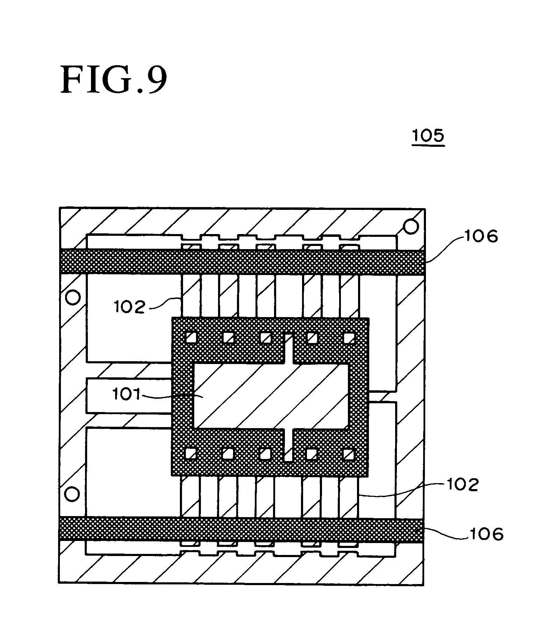

Fig.9 is a diagram showing a process for fabricating the optical module 100 (cutting predetermined portions 105b, 105c and 105d of the lead frame 105).
Fig.10 is a diagram showing a process for fabricating the optical module 100 (mounting LE platform 120).
Fig.11 is a diagram showing a process for fabricating the optical module 100 (mounting PD platform 110).
Fig.12 is a plan view schematically showing the structure of an optical module 200 according to another preferred embodiment of the present invention.
Fig. 13 is a side view partially showing the structure of the optical module 200.
Fig.14 is a plan view schematically showing the structure of an optical module 300 according to another preferred embodiment of the present invention.
Fig. 15 is a side view partially showing the structure of the optical module 300.
Fig.16 is a plan view schematically showing the structure of an optical module 400 according to another preferred embodiment of the present invention.
Fig. 17 is a side view partially showing the structure of the optical module 400.
Fig. 18 is a perspective view schematically showing the 1 of a dual channel optical module 500 according to another preferred embodiment of the present invention.
Fig. 19 is a perspective view schematically showing the exterior of a dual channel optical module 600 according to another preferred embodiment of the present invention
Fig.20 is a schematic view showing the structure of a conventional optical module.
Fig.21 is a schematic view showing the structure of another conventional optical module.

### DESCRIPTION OF THE PREFERED EMBODIMENT

Preferred embodiments of the present invention will now be explained with reference to the drawings.

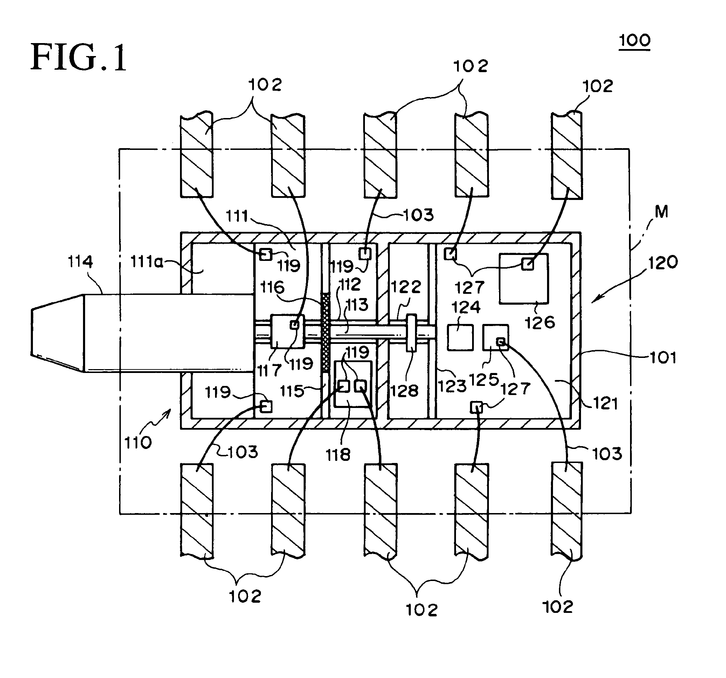

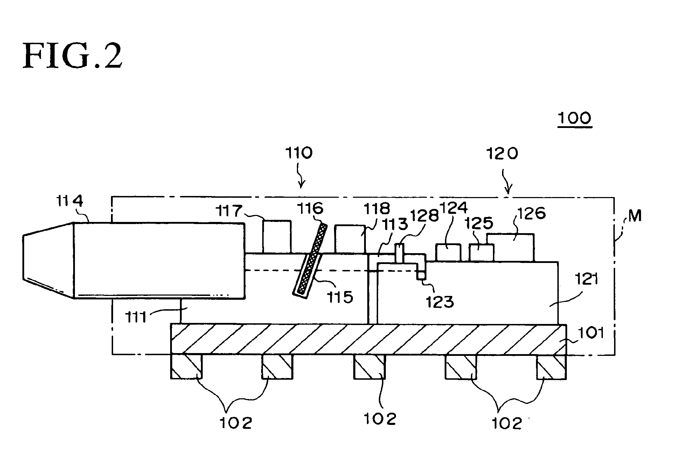

Fig.1 is a plan view schematically showing the structure of an optical module 100 according to one preferred embodiment of the present invention. Fig.2 is a side view partially showing the structure of the optical module 100. As explained later in detail, the optical module 100 of this embodiment is finally encapsulated and the main portions are covered with resin. Fig.1 therefore shows the state with the resin removed from the optical module 100. In Figs. 1 and 2, the region shown by M is the portion encapsulated in resin at the final stage. Further, the transceiver ICs, leads and bonding wires are also omitted.

As shown in Fig. 1 and 2, the optical module 100 according to this embodiment has a die pad 101, two or more leads 102, and a PD (Photodiode) platform 110 and LE (Light Emitter) platform 120 which are mounted on the die pad 101.

The die pad 101 and the leads 102, which are formed by cutting or etching a lead frame, are made of metal. The kind of the metal is not particularly limited but a metal used for a conventional lead frame, for example, an alloy including copper as the main component, an alloy including iron as the main component (such as 42-alloy (A42)) or the like, is preferably used. That is, an alloy excellent in conductivity, thermal conductivity, mechanical strength and the like is preferably used. The thickness of the die pad 101 is set to the thinnest value capable of ensuring the desired mechanical strength. It is not particularly limited but is preferably set between 0.1mm and 0.25mm. The area of the die pad 101 is set based on the base area of the PD platform 110 and LE platform 120 mounted on the die pad 101.

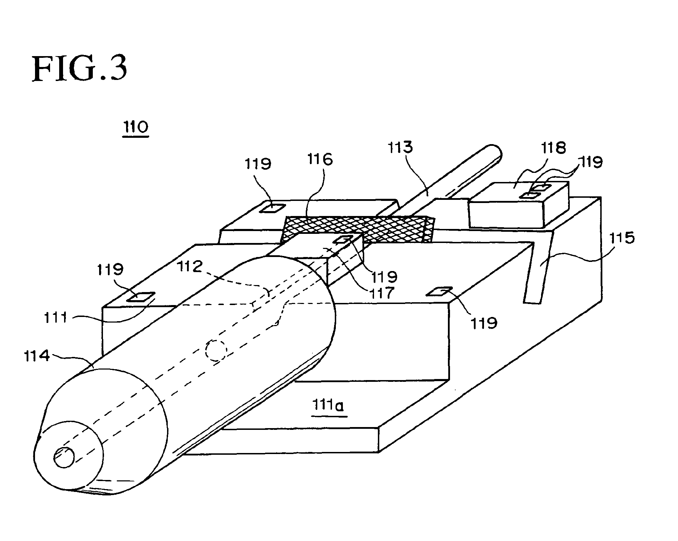

The PD platform 110 is a platform on which various parts for transforming optical signals supplied from the optical fiber into electric signals are mounted. A perspective view of the PD platform 110 is shown in Fig.3.

As shown in Figs. 1 through 3, the PD platform 110 comprises a PD platform body 111 made of silicon or the like, a groove 112 formed on the upper surface of the PD platform body 111, an optical fiber 113 accommodated in the groove 112, a ferrule 114 provided at the end of the optical fiber 113, a slit 115 formed on the upper surface of the PD platform body 111 so as to cross the groove 112, a WDM filter 116 inserted in the slit 115, and a receiving photo-diode 117 and receiving IC 118 mounted on the upper surface of the PD platform body 111. Further, bonding pads 119 are formed on the upper surface of the PD platform body 111, on the receiving photo-diode 117 and on the receiving IC 118.

The PD platform body 111 is made of a silicon block or the like. A step 111a is cut at the portion on the PD platform body 111 where the ferrule 114 is mounted, and the ferrule 114 is supported by the step 111a. Such a step 111a can be formed by chemical etching or mechanical dicing. Although not illustrated, an insulation film coating, such as an oxide film or a nitride film, is also formed on the upper surface of the PD platform body 111. The pad electrodes, wiring and the like connecting with some of the bonding pads 119, the receiving photo-diode 117 and the like are provided on the insulation film coating.

The groove 112 is a guidance groove for holding the optical fiber 113. Its width and depth are set large enough to accommodate the optical fiber 113. It can also be formed by chemical etching or mechanical dicing. The optical fiber 113 accommodated in the groove 112 is fixed by adhesive (not illustrated).

As known widely, an optical fiber is a fiber-shaped optical waveguide which consists of a core and a cladding surrounding the core, and light propagation can be attained by utilizing the difference of these refractive indexes. The end surfaces of the optical fiber 113 are made flat and smooth by polishing.

As known widely, a ferrule has a cylindrical shape which can hold an optical fiber, and one end of the optical fiber 113 terminates inside of the ferrule 114. By inserting one polished end of another optical fiber into the ferrule 114, it is possible to accomplish optical coupling between the two optical fibers.

The slit 115 is formed on the upper surface of the PD platform body 111 so as to cross the groove 112. Its width and depth are set according to the size of the WDM filter 116 inserted into it. If the width of the slit 115 is wider than necessary, diffraction loss will increase. Thus, the width of the slit 115 is set only slightly larger than the thickness of the WDM filter 116. The slit is provided at a predetermined angle so that the light propagating through the optical fiber 113 from the side of the ferrule 114 reflects at the WDM filter 116 and advances in a direction above the upper surface of the PD platform body 111. The angle of the slit 115 is not particularly limited but it is preferably set at an angle of about 30 degree to a plane perpendicular to the upper surface of the PD platform body 111. The slit 115 can also be formed by the chemical etching or the mechanical dicing. However, it is preferably formed by mechanical dicing because, differently from the step 111a and the groove 112, it needs to be formed at the predetermined angle while simultaneously cutting the optical fiber 113.

The WDM filter 116 is an optical filter which transmits light of the transmission wavelength (for example, about 1.3 µm) and reflects light of the reception wavelength (for example, about 1.55 µm). Since the WDM filter 116 is inserted into the slit 115 formed at the above-mentioned predetermined angle, it reflects light of the reception wavelength propagating through the optical fiber 113 from the side of the ferrule 114 upwardly of the PD platform body 111, while it transmits light of the transmission wavelength propagating through the optical fiber 113 from the side of the LE platform 120 toward the side of the ferrule 114. In addition, the slit 115 for inserting the WDM filter 116 is filled with an optical resin (not illustrated), thus the WDM filters 116 are securely fixed by the resin in the slit 115.

The receiving photo-diode 117 is an element that detects light of the reception wavelength reflected by the associated WDM filter 116 at its bottom surface and transforms the optical signals into electric signals. The receiving photo-diode 117 is mounted so as to straddle the groove 112 at the position where light reflected from the WDM filter 116 can be received.

The receiving IC 118 is a device for at least receiving and processing the output signals of the associated receiving photo-diode 117. Transfer of the data between the receiving IC 118 and the receiving photo-diode 117 is performed through the wiring pattern (not shown) formed on the upper surface of the PD platform body 111, and transfer of the data between the receiving IC 118 and a terminal device (not shown) is performed through the bonding pads or the leads (not illustrated). Moreover, if, as shown in Figs. 1 and 3, a bonding pad 119 is formed on the photo-diode 117, the transfer of some of the data or the supply of power between the receiving photo-diode 117 and the terminal device (not illustrated) can be performed directly. Although only a single receiving IC 118 is mounted on the PD platform 110 in this embodiment, the number of receiving ICs is not particularly limited and two or more ICs may be mounted. Moreover, it is also possible to omit the receiving IC 118 if the signal from the receiving photo-diode 117 is processed by another IC not mounted on the PD platform 110.

The PD platform 110 is configured as explained above.

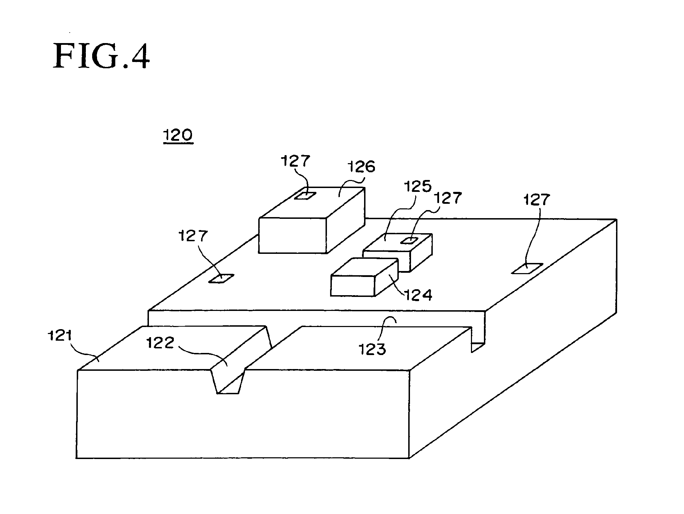

The LE platform 120 is a platform on which various components for transforming electric signals supplied from the terminal device into optical signals and transmitting them through the optical fiber 113 are mounted. A perspective view of the LE platform is shown in Fig. 4. Fig.4 shows the state before mounting the LE platform 120 on the die pad 101, and the optical fiber 113 and the like are not illustrated.

As shown in Figs.1, 2, and 4, the LE platform 120 comprises a LE platform body 121 made of silicon or the like, a V groove 122 formed on the upper surface of the LE platform body 121, a trench 123 formed on the upper surface of the LE platform body 121 so as to cross the end of the V groove 122, and a light emitter 124, a monitoring photo-diode 125, a transmitting IC126 mounted on the upper surface of the LE platform body 121, and bonding pads 127 formed on the top surface of the LE platform body 121, the monitoring photo diode 125, the transmitting IC 126 and the like.

The LE platform body 121 is made of a silicon block or the like, similarly to the PD platform body 111. Although not illustrated, an insulation film coating, such as an oxide film or a nitride film, is also formed on the upper surface of the LE platform body 121. Some of the bonding pads 127, the pad electrodes, or the wiring connected with some of the bonding pads, the light emitter 124 and the like are provided on the insulation film coating.

The V groove 122 is a guidance groove for correctly aligning the optical fiber 113 mounted therealong, and its shape is defined so that the end of the optical fiber 113 faces the light projecting surface of the light emitter 124 correctly. The V groove 122 can also be formed by chemical etching or mechanical dicing. Chemical etching is more preferable because it is necessary to position the optical fiber 113 correctly.

The trench 123 is provided so as to make the end of the V groove 122 a vertical plane. This is done because the end may become taper-like when the V groove 122 is formed by chemical etching, and in such a case, it becomes difficult to orient the optical fiber 113 and the light projecting surface of the light emitter 124 in the correct opposing relationship. In order to correctly oppose the end of the optical fiber 113 and the light projecting surface of the light emitter 124, the end of the V groove 122 needs to fall in a vertical plane, and in order to realize this, the trench 123 is formed. The trench 123 can also be formed by chemical etching or mechanical dicing. Although the trench 123 is extended from one side to the other side on the LE platform, it may be formed only on a part of the LE platform 125 necessary for correctly opposing the end of the optical fiber 113 and light projecting surface of the light emitter 124.

The light emitter 124 is an element for generating the light projected into the optical fiber 113. It can be a laser diode (LD) or a light emitting diode (LED). The light emitter 124 has two opposing light projecting surfaces. One light projecting surface is located on the side of the V groove 122, and the other light projecting surface is located on the side of the monitoring photo-diode 125. Therefore, part of the light from the light emitter 124 is supplied to the optical fiber 113 installed in the V groove 122, and the remainder is supplied to the monitoring photo-diode 125.

The monitoring photo-diode 125 is used to receive the light from the other light projecting surface of light emitter 124 and to monitor its intensity. The output of the monitoring photo-diode 125 is supplied to the associated transmitting IC 126, which optimizes the luminescence intensity of light emitter 124.

The transmitting IC 126 is a device for receiving at least the signal transmitted from a terminal device and the output signal of the monitoring photo-diode 125, processing these signals, and driving the light emitter 124. Transfer of the data between the transmitting IC 126 and light emitter 124 or the transmitting IC 126 and the monitoring photo-diode 125 is performed through the wiring pattern (not shown) provided on the upper surface of LE platform body 121. Transfer of the data between the transmitting IC 126 and the terminal device (not illustrated) is performed through the bonding pad 127 and a lead 102. Moreover, as shown in Figs. 1 and 4, if bonding pads 127 are formed on the monitoring photo-diode 125 and the like, the transfer of some of the data between the terminal (not illustrated) and the monitoring photo-diode 125 and the supply of power can be performed directly. In addition, although a single transmitting IC 126 is mounted on the LE platform 120 in this embodiment, the number of the transmitting ICs is not limited to one but can be two or more. Moreover, it is also possible to omit the transmitting IC 126 when the light emitter 124 is driven by another IC not mounted on the LE platform 120.

The optical module. 100 of this embodiment is completed by mounting the PD platform 110 and the LE platform 120 of the foregoing structure in order on die pad 101, connecting the bonding pads 119, 127 and the leads 102 by the bonding wires 103, and encapsulating the area M with resin.

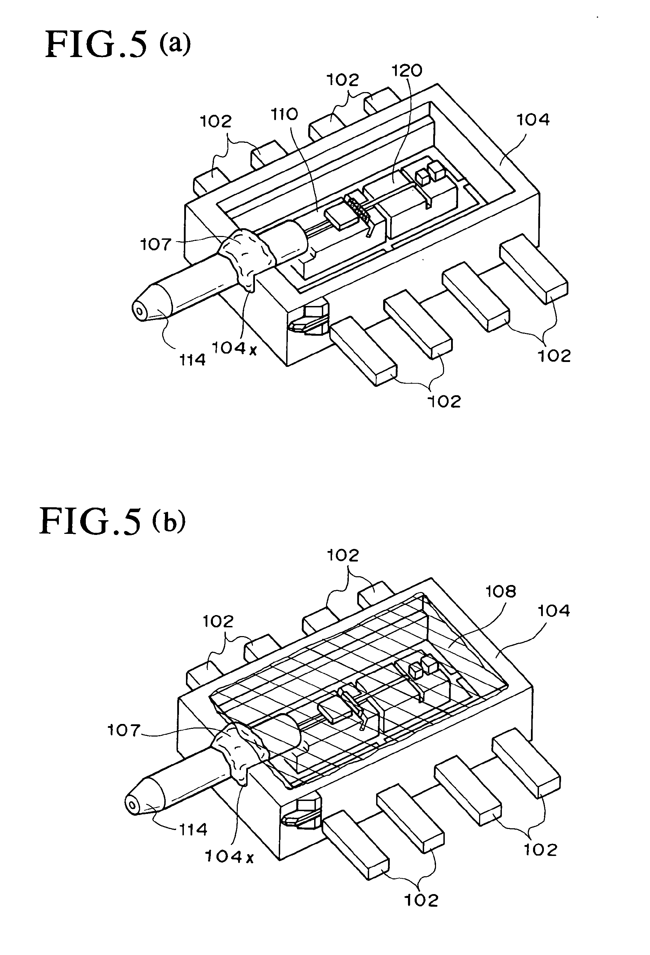

Fig.5 (a) and Fig.5 (b) are perspective views schematically showing the exterior of the optical module 100 according to this embodiment, wherein the Fig.5 (a) shows the state where a package box is not filled with resin and Fig.5 (b) shows the state where the package box is filled with resin.

As shown in Fig.5 (a) and Fig.5 (b), the optical module 100 according to this embodiment has a package box 104, which is an approximately box-shaped enclosure that accommodates the PD platform 110 and the LE platform 120. The leads 102 project from two side surfaces of the package box 104 and the ferrule 114 projects from a surface other than these two side surface. Thus, the external shape of the optical module 100 is similar to that of a commonplace semiconductor packaging device. It is therefore possible to mount it on the printed circuit board similarly to an ordinary semiconductor device. The optical module 100 can therefore be handled easily.

The package box 104 is formed so as to have sufficient height for accommodating the LE platform 110 and the PD platform 120. Although not visible in the drawing, a recess 104x is formed at the top of one sidewall of the package box 104 on the side from which the ferrule 114 projects. Further, adhesive 107 is used to fill the gap between the recess and ferrule. The adhesive 107 is injected into the gap between the recess and the ferrule and is also applied on the upper part of the ferrule near the recess.

As shown in Fig.5 (b), the internal space of the package box 104 accommodating the PD platform 110 and the LE platform 120 is filled with thermosetting resin 108. The thermosetting resin 108 is in a liquid or fluid during the manufacturing process. It cures by heating, and the curing of the resin is promoted by doping it with a curing agent. The thermosetting resin is injected into the package box 114 and the resin is cured to finally encapsulate the whole platform body with the resin. Thus, flow-out of the thermosetting resin is prevented.

Since the package box accommodating the LE platform and the PD platform is encapsulated with resin as described above, it is therefore possible to pack the optical module without using a molding machine and a metal mold.

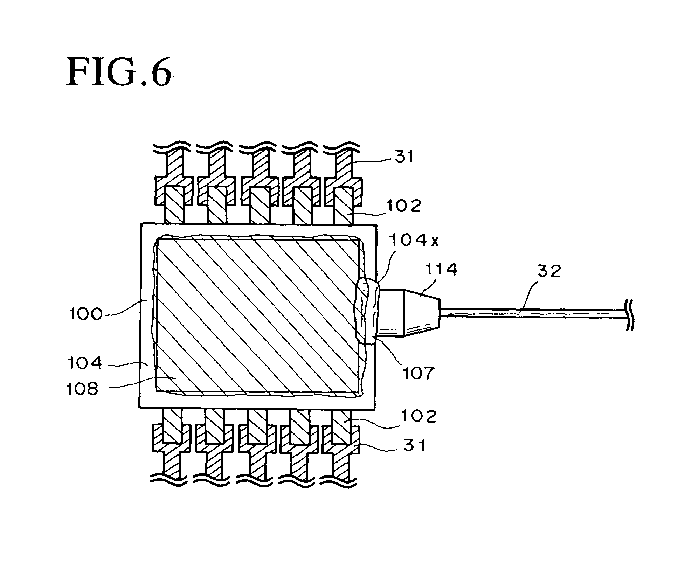

Fig.6 is top view schematically showing the optical module 100 mounted on a printed circuit board or the like. As shown in Fig.6, when mounting the optical module 100 on a printed circuit board, the leads 102 of the optical module 100 are mechanically and electrically connected with an electrode pattern 31 formed on the printed circuit by soldering, and another optical fiber 32 is inserted into the ferrule 114 and fixed. The optical module 100 can communicate electrically with an associated terminal device through the electrode pattern 31, and it can communicate optically through the optical fiber 32.

Next, a method of fabricating the optical module 100 according to this embodiment will be explained in detail.

At first, the method of fabricating the PD platform 110 will be explained. In fabricating the PD platform 110, a block member of silicon or the like to serve as the PD platform body 111 is first prepared, an insulation film coating, such as an oxide film or a nitride film, is formed on the surface of the block member, electrodes such as the bonding pads 119 and wiring patterns are formed on the insulation film coating, and a step 111a and a groove 112 are is formed on the PD platform body 111 by chemical etching or mechanical dicing. The step 111a and the groove 112 may be formed before forming the insulation film coating, electrodes and the like. Furthermore, the electrodes may be formed after forming the step 111a, the groove 112 and the insulation film coating.

On the other hand, both ends of the optical fiber 113 are polished and one end is inserted and fixed in the ferrule 114. As mentioned above, the optical fiber 113 is prepared by attaching the ferrule 114 to its one end is accommodated in the groove 114, and optical fiber 113 is fixed with adhesive. At this time, as shown in Fig.3, it necessary for the optical fiber 113 to extend a predetermined length from the edge of the PD platform body.

Next, the slit 115 is formed by chemical etching or mechanical dicing, preferably by mechanical dicing, and the WDM filter 116 is inserted into the slit 115. And the excess space of the slit 115 is filled with optical resin, thereby fixing the WDM filter 116 in the slit 115.

Next, the transmitting photo-diode 117 and the transmitting IC 118 are mounted on the electrode pattern formed on the PD platform body. This completes the PD platform 110.

Next, a method of fabricating the LE platform 120 will be explained. In fabricating the LE platform 120, a block member of silicon or the like to serve as the LE platform body 121 is prepared in a manner similar to the fabrication of the PD platform 110. An insulation film coating, such as an oxide film or a nitride film, is formed on the surface of the block member, and a V groove 122 is formed at a predetermined location on the LE platform body by chemical etching or mechanical dicing, preferably chemical etching. A trench 123 is formed on the LE platform body 121 by chemical etching or mechanical dicing, preferably mechanical dicing. The V groove 122 and the trench 123 may be formed before forming the insulation film coating, electrode and the like. Furthermore, the electrodes may be formed after forming the V groove 122, the trench 123 and the insulation film coating. However, it is necessary to form the trench 123 after forming at least the V groove 122.

Next, the light-emitter 124, the monitoring photo-diode 125 and the receiving IC 126 are mounted on the electrode pattern formed on the LE platform body. This completes the LE platform 110.

Next, a method of mounting the PD platform 110 and the LE platform 120 on the die pad 101 will be explained.

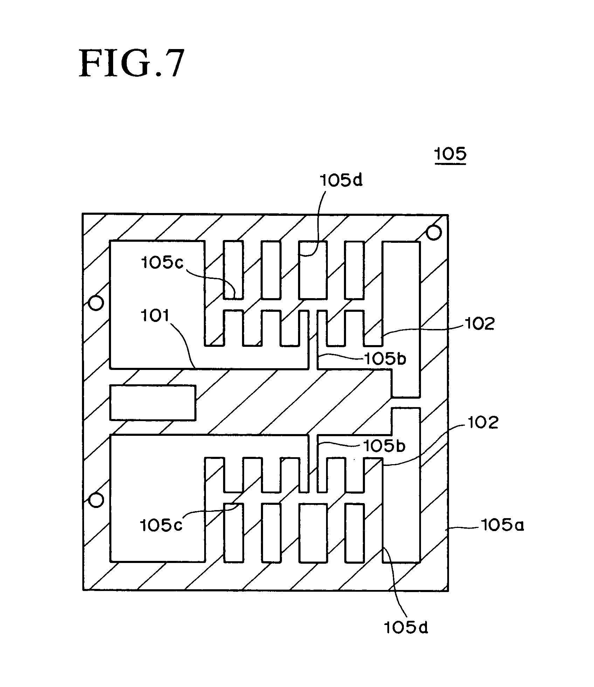

First, as shown in Fig.7, a lead frame 105 including the die pad 101 and the leads 102 is prepared. Such a lead frame 105 can be produced by punching or etching a metal plate.

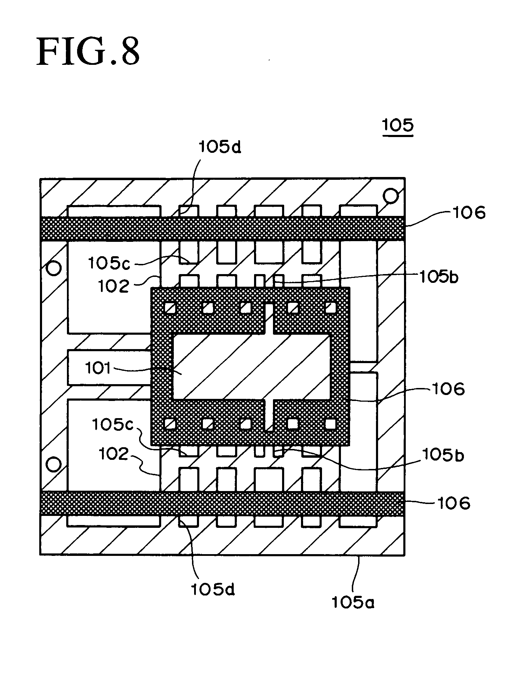

Next, as shown in Fig.8, the die pad 101 and one tip portion of the leads 102 are connected with resin 106, such as PPS (polyphenylene sulfide), and further, each lead 102 and an outer frame 105a of the lead frame 105 are connected (pre-molding). The resin 106a serves not only to interconnect the die pad 101 and one tip portion of the leads 102, but also as a package box 104., It is therefore formed as a box-shaped enclosure of sufficient height to accommodate the whole optical module. On the other hand, the resin 106b serves only to interconnect the die pad 101 and one tip portion of the leads 102. Injection molding or transfer molding using solid resin pellets is commonly performed in pre-molding and a molding machine and a metal mold are used.

After such pre-molding, the portions 105b interconnecting the die pad 101 and leads 102, the portions 105c interconnecting the leads 102, and the portions 105d interconnecting the leads 102 and the outer frame 105a of the lead frame 105 are cut. Thereby the die pad 101, the leads 102 and the outer frame of the lead frame 105 are electrically separated from one another. In this state, since the die pad 101 and leads 102 are connected by the resin 106a, and further the leads 102 and the outer leads 105a of the lead frame 105 are connected by the resin 106b, they are kept in an integrated state.

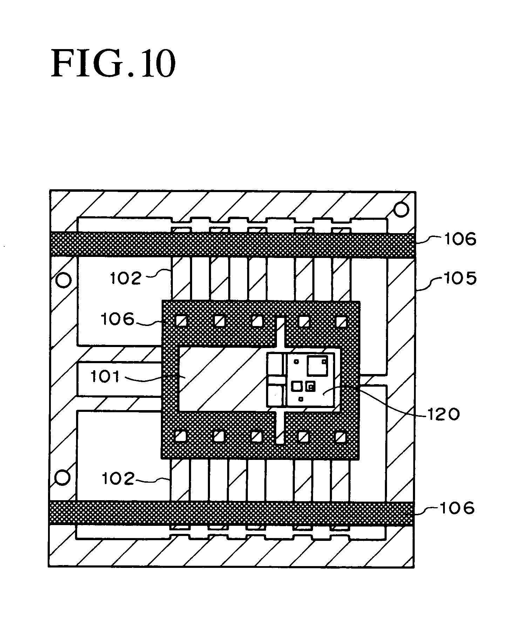

Next, as shown in Fig.10, the LE platform 120 is mounted on a predetermined portion of the die pad 101, and the bonding pads 127 and the predetermined leads 102 are connected electrically by the bonding wires 103. Next, in this state, an electric signal is transmitted to the LE platform 120 through the leads 102 connected to the bonding wires 103, and a screening test is performed. The screening test is a test for discovering initial failure of the light emitter 124 by maintaining application of a few hundred mA of driving current to the emitters 124 for a few hours. By monitoring the intensity of the signal detected with the monitoring photo-diodes, it is possible to discover any initial failure of the light emitters 124. Subsequent fabricating processes are performed only on products in process that pass the screening test, and no subsequent process is performed on products in process in which initial failure of the light emitter 124 was discovered in the screening test. It is therefore possible to eliminate pointless processing.

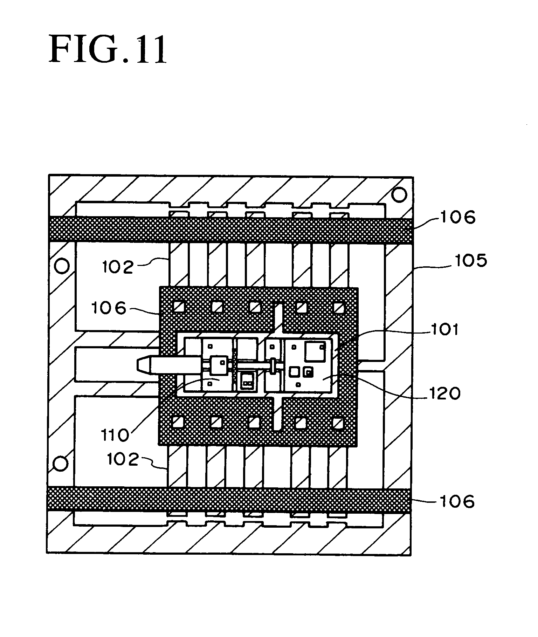

When the screening test is passed,, the PD platform 110 is mounted on a predetermined area of the die pad 101, as shown in Fig.11, and the optical fiber 113 is arranged along the V groove 122, by which the end of the optical fiber 113 is made to face to the light emitting surface of the light emitter 124 correctly. Next, adhesive 128 (See Figs.1 and 2) is applied to the optical fiber 113 installed in the V groove 122 and hardened, by which the optical fiber 113 is fixed in the V groove 122. The material of adhesive 128 is not particularly limited but a thermosetting resin or ultraviolet-light curable resin can be used. Moreover, the optical fiber 113 may be fixed by lids, such as of silicon or quartz, instead of the adhesive 128.

Next, the bonding pads 119 and the predetermined leads 102 are connected electrically with bonding wires 103, after which silicone gel is applied onto all optical functional elements, such as the photo diode for reception 117, light emitter 124 and the like. Such silicone gel mainly serves as ensuring propagation of the light signals between the light emitter 124 and optical fiber 113 and as a buffer for protecting the optical functional elements, such as the light emitter 124 and the like, from mechanical stress from outside. The mechanical stress is absorbed by the silicone gel.

Further, as shown in Fig.5 (b), the inside of the package is filled with thermosetting resin or ultraviolet-light resin, the resin is cured and the leads 102 are cut. This completes the optical module 100.

As described above, since the PD platform 110 and the LE platform 120 are mounted on a single die pad 101 and these are encapsulated integrally by resin, the optical module 100 of this embodiment can be handled very easily. Further, differently from the conventional optical module, the optical module 100 does not require fine tuning by a skilled worker and is therefore high in fabricating efficiency. It is therefore possible to realize relatively low cost as compared with the optical module 20 including the conventional optical waveguide shown in Fig.21.

Further, if the LE platform 120 is first mounted on the die pad 101 and the PD platform 110 is then mounted, the parts on the PD platform 110 will not be affected by the heat imparted when mounting the light emitters 124 and the like on the LE platform body 121. Accordingly, it becomes easy to control temperature at each process in the fabrication.

Furthermore, in the fabrication of the optical module 100 of this embodiment, the PD platform 110 is mounted after mounting the LE platform 120 on the die pad 101 and carrying out a screening test. As a result, it is not necessary to perform needless processing on a product in process that has an initial failure, and is therefore possible to reduce manufacturing cost.

Furthermore, since the package box formed by pre-molding has a box shape capable of accommodating the PD platform and the LE platform, it is possible to encapsulate the internal space of the package box accommodating the LE platform and the PD platform with liquid resin or fluid resin. It is therefore possible to pack the optical module easily without using a molding machine and metal mold in final packaging.

Although receiving IC 118 is mounted on the PD platform body 111 and the transmitting IC 126 is mounted on the LE platform body 121 in the above optical module 100, these may be mounted on the die pad 101 in the present invention. Next, an embodiment in which the receiving IC and the transmitting IC are mounted on the die pad will be explained.

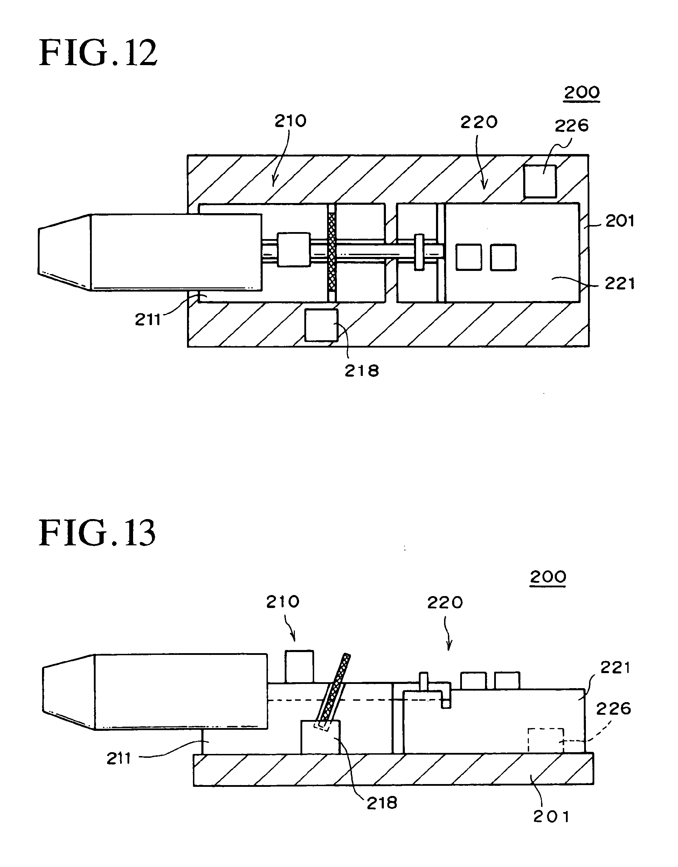

Fig.12 is a plan view schematically showing the structure of an optical module 200 according to another preferred embodiment of the present invention. Fig.13 is a side view partially showing the structure of the optical module 200. As explained later in detail, the optical module 200 of this embodiment is finally encapsulated and the main portions are covered with resin. Figs.12 and 13 therefore show the state with the resin removed from the optical module 200. Further, the transceiver ICs, leads and bonding wires are also omitted in Figs. 12 and 13.

As shown in Figs. 12 and 13, the optical module 200 according to this embodiment has a PD platform 210 and an LE platform 220 which are mounted on a die pad 201, similarly to the optical module 100 according to the above embodiment. However, it is different from the optical module 100 according to the above embodiment in the point that the receiving IC 218 and the transmitting IC 226 are mounted on the die pad 201. In other aspects, the configuration is as same as that of the optical module 100.

The optical module 200 according to this embodiment offers the same advantages as the optical module 100 according to the above embodiment. Further, since the receiving IC 218 and the transmitting IC 226 are not mounted on the PD platform body 211 and the LE platform body 221 but are mounted on the die pad 201, it is possible to miniaturize the platform bodies 211 and 221. Thus, it is possible to reduce the manufacturing cost as well as the cost of materials, because a large number of platform bodies can be produced at one time by cutting a silicon wafer into many pieces.

In addition, in the optical module 200 according to the present invention, although two ICs are mounted on the die pad 201, the number of ICs mounted on the die pad 201 may be only one or three or more. Further, a predetermined IC may be mounted on the die pad 201 and the other IC may be mounted on the PD platform body 211 and/or the LE platform body 221.

Although both the PD platform 110 (210) and the LE platform 120 (220) are mounted on the die pad 101 (201) in the above optical module 100 (200), the PD platform need not be mounted on the die pad but can be mounted on the LE platform in the present invention. Next, an embodiment in which the PD platform is mounted on the LE platform will be explained.

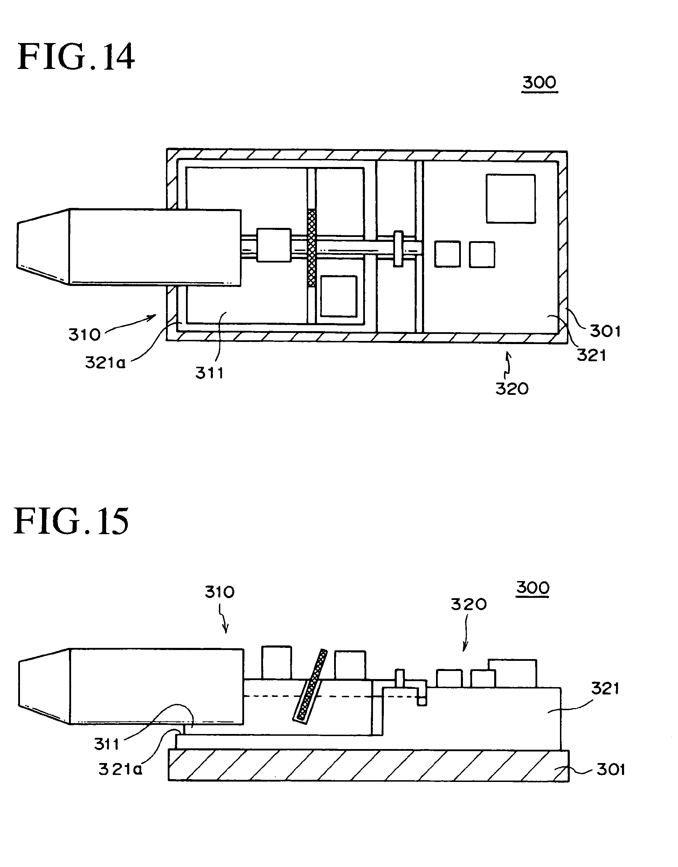

Fig. 14 is a plan view schematically showing the structure of an optical module 300 according to another preferred embodiment of the present invention. Fig.15 is a side view partially showing the structure of the optical module 300. As explained later in detail, the optical module 300 of this embodiment is finally encapsulated and the main portions are covered by a resin. Figs. 14 and 15 therefore show the state with the resin removed from the optical module 300. Further, the transceiver ICs, leads and bonding wires are also omitted in Figs.14 and 15.

As shown in Figs. 14 and 15, the optical module 300 according to this embodiment has a PD platform 310 and an LE platform 320, similarly to in the optical module 100 according to the above embodiment. However, it is different from the optical module 100 and the like according to the above embodiments in the point that the PD platform 310 is not mounted on the die pad 301 but on a region 321a provided on the LE platform body 321 of the LE platform 320. In other aspects the configuration is as same as that of the optical module 100.

The optical module 300 according to this embodiment offers the same advantages as the optical module 100 according to the above embodiment. Further, since the PD platform 310 and the LE platform 320 are substantially integrated, there is an advantage that the positional relationship between the light emitter 124 and the optical fiber 113 cannot change easily even if the shape of the die pad 301 changes slightly owing heat stress.

Although the PD platform 110 (210, 310) and LE platform 120 (220, 320) are independent components in the above optical module 100 (200, 300), these may be constituted as a single platform. Next, an embodiment in which the single platform is mounted on the die pad will be explained.

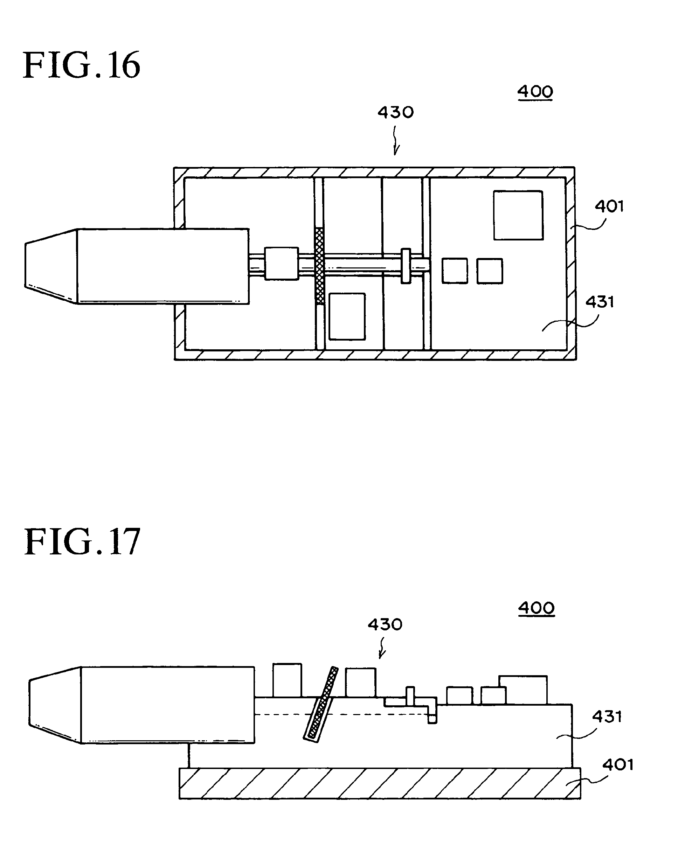

Fig.16 is a plan view schematically showing the structure of an optical module 400 according to another preferred embodiment of the present invention. Fig.17 is a side view partially showing the structure of the optical module 400. As explained later in detail, the optical module 400 of this embodiment is finally encapsulated and the main portions are covered with resin. Figs. 16 and 17 therefore show the state with the resin removed from the optical module 400. Further, the transceiver ICs, leads and bonding wires are also omitted in Fig.16 and 17.

As shown in Fig. 16 and 17, the optical module 400 according to this embodiment has a common platform 430 mounted on a die pad 401, differently from the optical module 100 and the like according to the above embodiments. The common platform 430 consists of a single platform body 431 and serves as both the PD platform 110 and the LE platform 120. Although the optical module 400 does not allow a screening test to be conducted only with respect to the LE platform, it otherwise offers the same advantages as the optical module 100 according to the above embodiment. Further, it is the optical module with the easiest fabricating process and, as such, enables a reduction of manufacturing cost.

Although the above mentioned optical modules are single channel type optical modules comprising a single input/output optical terminal, the present invention can also be applied to a multi-channel optical module.

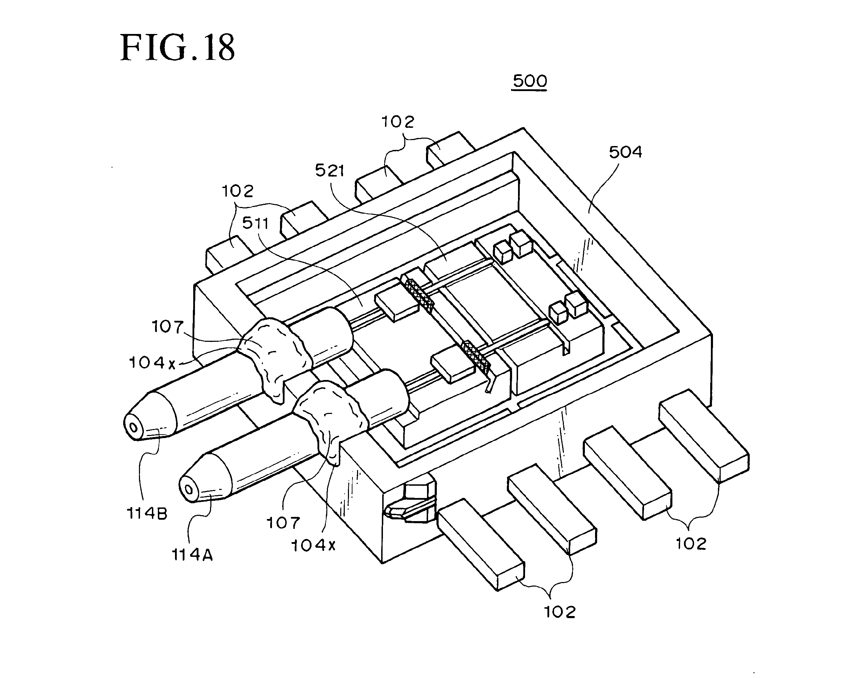

Fig.18 is a perspective view schematically showing the exterior of a dual channel optical module according to another preferred embodiment of the present invention. It is shown in the state before final encapsulation in resin.

As shown in Fig. 18, in the optical module 500 of this embodiment, two transceiver units oriented in the same direction and are arranged in parallel on the PD platform body 511 and the LE platform body 521 accommodated in the package box. Two ferrules 114A and 114B project from inside of the package box 504 in the same direction. Although not illustrated, two recesses corresponding to these ferrules are formed in the package box 504, and adhesive 107 is charged into the gap between the recesses and the ferrules and onto the top surfaces of the ferrules. The internal space of the package box 504 accommodating the platforms is finally filled with liquid resin, such as thermosetting resin or the like, after which the resin is cured. Thus, whole platform body is encapsulated with the resin.

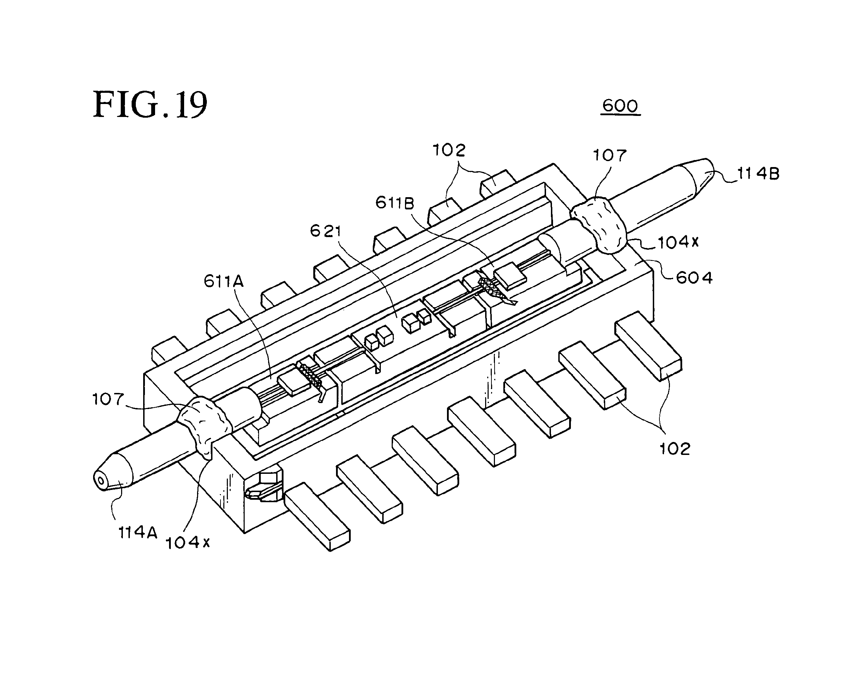

Fig. 19 is a perspective view schematically showing the exterior of the dual channel optical module according to another preferred embodiment of the present invention. It is shown in the state before final encapsulation in resin.

As shown in Fig. 19, in the optical module 600 of this embodiment, two transceiver units oriented in opposite directions and are arranged in series, differently from the optical module 500 shown in Fig. 18. The platform for mounting the transceiver units consists of two independent PD platform bodies 611A and 611B for the two transceiver units and a single LE platform body 621 which is common to the two transceiver units. These are accommodated in the package box 604. The ferrules 114A and 114B project from inside the package box 504 in opposite directions. Although not illustrated, two recesses corresponding to these ferrules are formed in the package box 604, and adhesive 107 is charged into the gaps between these recesses and the ferrules and onto the top surfaces of the ferrules. Thus, although not illustrated, two recesses corresponding to these ferrules are formed one at either end of the package box 604, and adhesive 107 is charged into the gaps between these recesses and the ferrules and onto the top surfaces of the ferrules. The internal space of the package box 504 accommodating the platforms is finally filled with liquid resin, such as thermosetting resin or the like, after which the resin is cured. Thus, the whole platform body is encapsulated with the resin.

As described above, the dual-cannel optical module including two transceiver units also has a package box accommodating the LE platform body and the PD platform body, and the package box is charged with liquid resin such as thermosetting resin, similarly to the single channel optical module. The packing can therefore be performed easily without using a molding machine and metal mold. Furthermore, the present invention can be applied to all types of multi-channel modules, such as ones in which several transceiver units are arranged in parallel, in a matrix of n rows and 2 columns ("n" being a positive integer), and the like, as in the case of the dual channel type shown in Figs. 18 and 19.

The present invention has thus been shown and described with reference to specific embodiments. However, it should be noted that the present invention is in no way limited to the details of the described arrangements but changes and modifications may be made without departing from the scope of the appended claims.

For example, in the above embodiments, the PD platform and the LE platform are encapsulated in resin. However, the encapsulation material is not particularly limited and another material may be adopted.

Moreover, in the above embodiments, the resin charged into the packaging body is a thermosetting resin. However, various resin, such as ultraviolet-curing resins and the like, may be used in the present invention.

In the above embodiments, the package box is a squire box-shaped enclosure. However, variously shaped enclosures, such as round, polygonal and the like, may be used in the present invention.

As described above, in the present invention, since the at least one platform body on which the receiving photo-diode and the light emitter are mounted is mounted on the die pad after which these are encapsulated by the resin, the optical module is very easy to handle. Since integrated encapsulation can be performed by injecting liquid resin into the package box accommodating the transceiver unit and curing the resin, the encapsulation can be easily performed without using a molding machine and a metal mold. Further, since, differently from the conventional optical module, the optical module does not require fine tuning by a skilled worker, it has high fabrication efficiency. It is therefore possible to realize relatively low cost, which is not possible with the optical module including the conventional optical waveguide.

Moreover, since the package box has a recess for projecting the ferrule, and the gap between the recess and the ferrule is filled with adhesive, it is possible to prevent the liquid resin filling the package box from leaking through the gap to the outside.

Moreover, since the screening test of the LE platform mounted on the die pad is performed before mounting the PD platform, it is not necessary to perform needless processing on a product in process that has an initial failure, and is therefore possible to reduce manufacturing cost. Further, since no molding machine and metal mold are required in the final resin encapsulation after performing the screening test, it is possible to realize easy packaging.

## Claims

1. An optical module for transmitting and receiving optical signals comprising:
at least one transceiver unit;
a package box which is a box-shaped enclosure accommodating the transceiver unit; and
resin filling the package box;
wherein the transceiver unit includes
a die pad;
at least one platform body mounted on the die pad;
an optical fiber fixed on the platform body;
at least one receiving photo-diode which is mounted on the platform body and transforms optical signals received through the optical fiber into electric signals;
a light emitter mounted on the platform body;
a filter provided to divide the optical fiber at a position between the receiving photo-diode and the light emitter; and
a ferrule in which an end of the optical fiber is inserted.

2. An optical module in accordance with claim 1, wherein the package box has a recess for projecting the ferrule, and the gap between the recess and the ferrule is filled with adhesive.

3. An optical module in accordance with Claim 1 or 2, wherein the adhesive is further applied on the upper part of the ferrule near about the recess.

4. A method of fabricating an optical module for transmitting and receiving optical signals comprising the steps of:
producing a box-shaped package box by pre-molding a lead frame;
mounting on a die pad of the lead frame an LE platform equipped at least with a light emitter for generating optical signals to be transmitted;
mounting on the die pad or the LE platform a PD platform equipped at least with an optical fiber, a receiving photo-diode for photoelectrically converting optical signals received through the optical fiber, a filter for separating received optical signals from transmitted optical signals, and a ferrule in which an end of the optical fiber is inserted,
charging resin into the package box accommodating the PD platform body and the LE platform body; and
curing the resin to encapsulate the PD platform and LE platform.

5. A method of fabricating an optical module in accordance with Claim 4,
wherein the step of pre-molding the lead frame includes a step of forming a recess in the package box for projecting the ferrule, and further comprises a step of injecting adhesive into a gap between the recess and the ferrule before the step of charging resin into the package box.

6. A method of fabricating an optical module in accordance with Claim 4 or 5 further comprising a step of:
performing a screening test of the LE platform mounted on the die pad before mounting the PD platform.
